**Europäisches Patentamt**

**European Patent Office**

**Office européen des brevets**

(19)

(11) Veröffentlichungsnummer: **0 327 881**

**A1**

# (12)   EUROPÄISCHE PATENTANMELDUNG

(21) Anmeldenummer: **89101226.2**

(22) Anmeldetag: **25.01.89**

(51) Int. Cl.⁴: **H03K 17/08 , //H02M3/335**

(30) Priorität: **10.02.88 DE 3804051**

(43) Veröffentlichungstag der Anmeldung:
**16.08.89 Patentblatt  89/33**

(84) Benannte Vertragsstaaten:
**AT BE CH DE ES FR GB GR IT LI LU NL SE**

(71) Anmelder: **Deutsche Thomson-Brandt GmbH
Hermann-Schwer-Strasse 3 Postfach 1307
D-7730 Villingen-Schwenningen(DE)**

(72) Erfinder: **Hartmann, Uwe
Passauer Strasse 49
D-8391 Untergriesbach(DE)**
Erfinder: **Mai, Udo
Obernederring 7
D-8391 Untergriesbach(DE)**
Erfinder: **Ohnemus, Fritz
An der Hammerhalde 13
D-7730 Villingen-Schwenningen(DE)**

(54)  **Schaltnetzteil.**

(57) Schaltungsanordnung mit einem gesteuerten elektronischen Schalter.

Bei Schaltnetzteilen muß eine Schutzschaltung vorgesehen werden, die den elektronischen Schalter (9) des Schaltnetzteils vor zu großen Strömen schützt. Da dieser Schalter (9) eine Ausschaltverzögerung besitzt, muß dieser einige Mikrosekunden vor Erreichen des maximal zulässigen Maximalstromes abgeschaltet werden. Der Strom, bei dem die Abschaltung spätestens erfolgen muß, wird derart eingestellt, daß bei der maximalen Eingangsspannung des Schaltnetzteils der Endwert des Stromes den maximal zulässigen Strom nicht überschreitet. Bei einer niedrigeren Eingangsspannung bleibt nach Ansprechen der Schutzschaltung der Endwert des Stromes wegen des geringeren Stromanstieges weit unterhalb von diesem Maximalstrom. Dadurch wird der Regelbereich eingeengt und der Wirkungsgrad wird verschlechtert

Die Erfindung beseitigt diesen Nachteil dadurch, daß die Ansprechschwelle für die Schutzschaltung (10, 12, 13, 14, 15, 16) in Abhängigkeit von der dem Schaltnetzteil zugeführten Eingangsspannung (U) gleitend ausgebildet ist.

Elektronische Geräte, insbesondere Fernsehempfänger.

## Schaltnetzteil

Die Erfindung betrifft eine Schaltungsanordnung mit einer in Serie zu einem elektronischen Schalter liegenden Induktivität sowie einem Stromsensor zur Messung des durch den elektronischen Schalter fliessenden Stromes, wobei bei Überschreiten eines vorgegebenen Maximalwertes dieses Stromes die den elektronischen Schalter leitend steuernden Impulse abgeschaltet werden.

Derartige Schaltungsanordnungen sind z.B. als Schaltnetzteile für elektronische Geräte vorgesehen, die mit gutem Wirkungsgrad über einen weiten Netzspannungsbereich arbeiten sollen. In einem Schaltnetzteil wird ein elektronischer Schalter verwendet, der in Abhängigkeit von der diesem zugeführten gleichgerichteten Netzspannung und in Abhängigkeit von der Belastung des Schaltneztteils mit in ihrer Breite veränderlichen Impulsen angesteuert werden, die aus einer Regelschaltung kommen. Je nach Regelung werden die Einschaltflanken der Impulse verschoben, die den elektronischen Schalter früher oder später einschalten. Die verwendeten elektronischen Schalter haben den Nachteil, daß sie nicht trägheitslos abschaltbar sind, sondern daß sie nach der Abschaltflanke der Ansteuerimpulse noch bis zu 10 usec. durchgeschaltet bleiben, so daß der Kollektorstrom durch die Ladespule des Schaltnetzteiltransformators für diese Zeitspanne weiterfliesst. Die Schutzschaltung, die den elektro nischen Schalter vor zu hohem Kollektorstrom schutzen soll, muß für die maximal zulässige Eingangsspannung des Schaltnetzteils dimensioniert werden. Das bedeutet aber, daß der Kollektorstrom bei kleinen Eingangsspannungen seinen maximal zulässigen Wert nicht erreicht, was einer Einengung des Regelbereichs gleichkommt. Dieses widerspricht jedoch der Forderung, die Schaltung immer bis zur Belastungsgrenze auszunutzen, was für die Preisgestaltung des Schaltnetzteils von wesentlicher Bedeutung ist. Die Schutzschaltung muß also derart ausgelegt sein, daß sie bei ungünstigsten Bedingungen z.B. bei höchster Eingangsspannung schon weit vor Erreichen des zulässigen Maximalstromes anspricht. Dieser Schutzstrom ergibt sich zu :

I schutz = Icmax - (U max - T)/L,

wobei Icmax der maximal zulässige Kollektorstrom durch den elektronischen Schalter, Umax die maximal vorkommende Eingangsspannung und T die Zeitdauer der Verzögerung des Abschaltbefehls und L der Wert der Induktivität der Speicherspule des Schaltnetzteils darstellt. Man erkennt, daß der Wert des Schutzstromes um den Wert des zweiten Summanden vermindert wird.

Der Erfindung liegt die Aufgabe zugrunde, den Nachteil einer Einengung des Regelbereichs zu vermeiden, so daß der elektronische Schalter immer bis zum maximal zulässigen Kollektorstrom beaufschlagt werden kann, so daß dieser voll ausnutzbar ist. Diese Aufgabe wird durch die im Patentanspruch angegebene Erfindung gelöst. Weitere Ausgestaltungen der Erfindung ergeben sich aus den Unteransprüchen.

Nachstehend werden anhand einiger Ausführungsbeispiele Schaltungsanordnungen beschrieben, die zur Lösung oben angeführter Aufgabe geeignet sind.

Figur 1 zeigt ein Diagramm zur Erläuterung des der Erfindung zugrunde liegenden Problems

Figur 2 zeigt ein erstes Ausführungsbeispiel einer Schaltungsanordnung

Figur 3 zeigt zweites Ausführungsbeispiel einer Schaltungsanordnung

Figur 4 zeigt ein Diagramm zur Darstellung der Auswirkung der Erfindung.

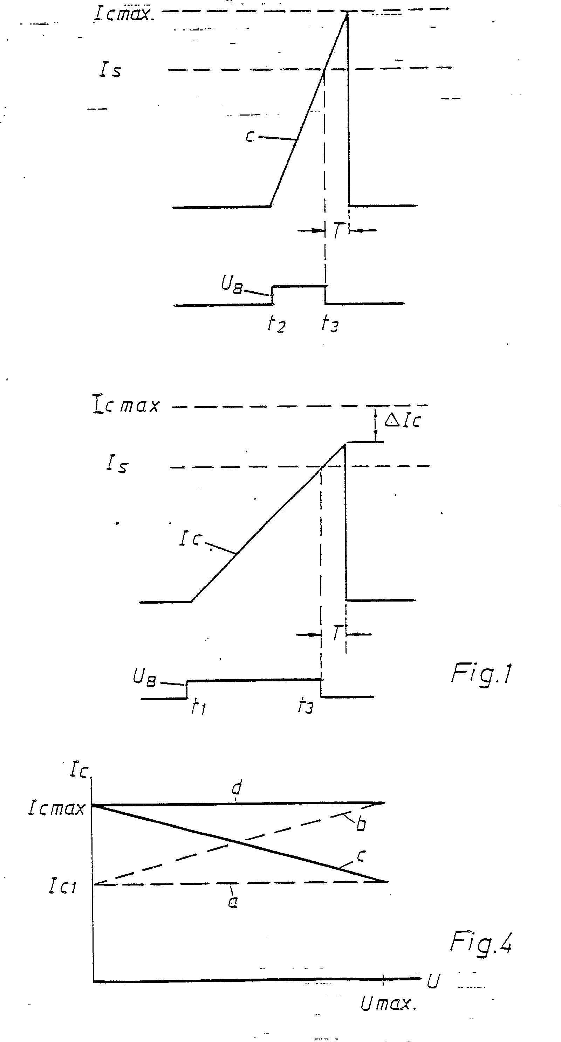

In Figur 1 ist im oberen Teil ein Ansteuerimpuls UB für den elektronischen Schalter dargestellt, dessen ansteigende Flanke bei einer hohen Eingangsspannung durch die Regelung aus einem Impulsbreitenmodulator ·zeitlich später, z.B. bei t2, auftritt. Bei Einschalten des elektronischen Schalters steigt der Kollektorstrom Ic durch die Ladespule des Schaltnetzteils linear an, der spätestens bei Erreichen des zulässigen Maximalstromes Icmax abgeschaltet werden muß. Da nach dem Abschalten des elektronischen Schalters zum Zeitpunkt t3 der Kollektorstrom Ic für die bis zum endgültigen Sperren des elektronischen Schalters vorhandene Zeitdauer T noch fliesst, muß dafür gesorgt werden, daß der elektronische Schalter bei einem wesentlich kleineren Schutzstrom bereits abgeschaltet wird. Der Schutzstrom wird derart gewählt, daß bei der größten Eingangsspannung, bei welcher der Anstieg des Kollektorstromes am größten ist, der elektronische Schalter bei Erreichen des Maximalstromes gerade abgeschaltet wird, d.h. nach der Zeit T nach Eintreffen der Abschaltflanke. Man erkennt im unteren Teil der Figur 1, daß bei einer kleineren Eingangsspannung der Stromanstieg von Ic wesentlich geringer ist, und daß der elektronische Schalter wesentlich früher, z.B. zum Zeitpunkt t1 eingeschaltet wird und daß nach Überschreiten des vorgegebenen Schutzstromes der elektronische Schalter nach der Zeit T abgeschaltet wird, daß aber auch der maximal zulässige Kollektorstrom Icmax gar nicht erreicht wird. Die Folge ist, daß der Wirkungsgrad des Schalt neztteils sinkt, da nach der bekannten Formel $W = L \times I^2/2$ die gespeicherte Energie quadratisch von dem Strom abhängt.

Nachstehend wird anhand von zwei möglichen Ausführungsbeispielen die Wirkungsweise der Schaltung beschrieben.

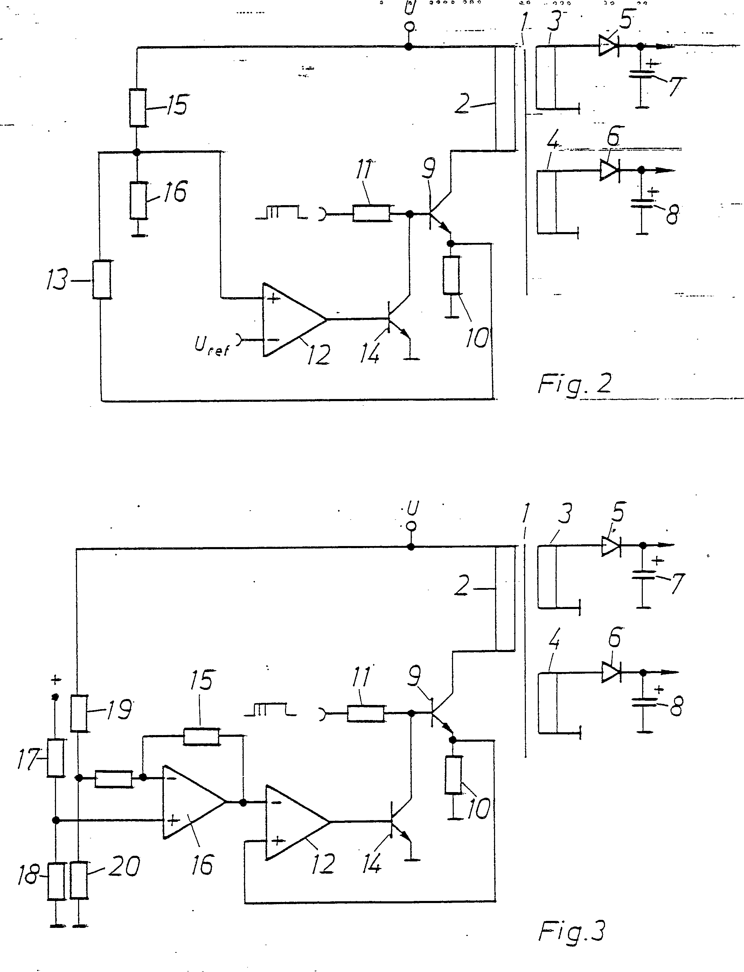

In Figur 2 ist ein Schaltnetzteiltransformator 1 mit einer Primärwicklung 2 sowie mehreren Sekundärwicklungen 3 und 4 dargestellt. Die Sekundärwicklungen 3 und 4 liefern über Gleichrichter 5 und 6 an Kondensatoren 7 und 8 mehrere Betriebsspannungen für ein elektronisches Gerät. Die Primärwicklung 2 liegt als Ladespule einerseits an einer gleichgerichteten Eingangsspannung U und andererseits über den elektronischen Schalter 9 und einen Fühlwiderstand 10 als Stromsensor an Massepotential. Über den Widerstand 11 wird der elektronische Schalter 9 aus einem nicht dargestellten Impulsbreitenmodulator angesteuert. Die an dem Fühlwiderstand 10 entstehende, dem Kollektorstrom Ic des elektronischen Schalters 9 proportionale Spannung wird dem einen Eingang (+) eines Komparators 12 über einen Widerstand 13 zugeführt. Der andere Eingang (-) des Komparators 12 liegt an einer Referenzspannung Uref. Überschreitet die am (+) Eingang des Komparators 12 liegende Spannung diese Referenzspannung, schaltet der Komparator 12 über eine Stufe 14 die Ansteuerimpulse für den elektronischen Schalter 9 kurz, so daß dieser abgeschaltet wird. Zusätzlich ist der (+) Eingang des Komparators 12 an eine zwischen der Eingangsspannung U und Bezugspotential geschalteten Spannungsteiler 15, 16 gelegt. Auf diese Weise wird der Komparator 12 je nach Höhe dieser Eingangsspannung U die Schaltstufe 14 durchschalten. Ist die Eingangsspannung höher, wird der gemessene Schaltungswert am Fühlwiderstand 10 eher die Schwelle des Komparators 12 erreichen. Auf diese Weise wird eine in Abhängigkeit von der Eingangsspannung U gleitende Schwelle erzeugt. Bei höheren Eingangsspannungen U schaltet der elektronische Schater 9 eher ab.

Eine weitere Schaltungsvariante ist in Figur3 dargestellt. Gleiche Bauteile sind mit den gleichen Bezugzeichen der Figur 2 versehen. Bei der Schaltung nach Figur 3 wird nicht der gemessene Absolutwert des Kollektorstroms Ic am (+) Eingang des Komparators 12 von der Eingangsspannung U beeinflusst, sondern es wird die Referenzspannung Uref am (-) Eingang des Komparators 12 verändert. Hierzu ist eine über den Widerstand 15 gegengekoppelte Verstärkerstufe 16 vorgesehen, an deren nicht-invertierenden Eingang (+) eine feste Referenzspannung gelegt ist, die von einem Spannungsteiler 17, 18 abgegriffen wird. An den invertierenden Eingang (-) des Differenzverstärkers 16 liegt die über den Spannungsteiler 19, 20 geteilte, den Schwankungen unterliegende Eingangsspannung U. Steigt diese Eingangsspannung an, sinkt dadurch die am Komparatorausgang liegende Referenzspannung. Dadurch schaltet der Komparator 12 die Schaltstufe 14 bereits bei einem kleineren Wert des Kollektorstroms Ic durch und umgekehrt.

In Figur 4 ist ein Diagramm dargestellt, in welchem in Abhängigkeit von der Eingangsspannung U der erzielbare Kollektorstrom Ic dargestellt ist. Die Linie a bezeichnet den bekannten bisher üblichen Verlauf der konstanten Schwelle, so daß immer bei einem gleichen Kollektorstrom Ic1 = I schutz die Schutzschaltung anspricht. Dadurch ist der Kollektorstrom bei kleinen Eingangsspannungen U klein und der zulässige Kollektorstrom Icmax wird nicht erreicht, wie dies Linie b verdeutlicht. Mit der angemeldeten Maßnahme wird die Größe des Kollektorstroms, bei dem die Schutzschaltung anspricht, in Abhängigkeit von der Eingangsspannung U verändert, wie dieses in Linie c dargestellt ist. Dadurch ist für jede Eingangsspannung der maximale Kollektorstrom Icmax erreichtbar (Linie d), also auch bei niedrigen Eingangsspannungen U.

Die zuvor beschriebene Schutzschaltung ist besonders gut für eine Integrierung geeignet.

## Ansprüche

1. Schaltungsanordnung mit einer in Serie zu einem elektronischen Schalter liegenden Induktivität sowie einem Stromsensor zur Messung des durch den elektronischen Schalter fliessenden Stromes, wobei bei Überschreiten eines vorgegebenen Maximalwertes dieses Stromes die den elektronischen Schalter leitend steuernden Impulse abgeschaltet werden, **dadurch gekennzeichnet, daß** die Ansprechschwelle für den vorgegebenen Maximalwert des Stromes in Abhängigkeit von der der Schaltungsanordnung zugeführten Eingangsspannung automatisch veränderbar ist.

2. schaltungsanordnung nach Anspruch 1, **dadurch gekennzeichnet, daß** die vorgebbare Ansprechschwelle bei steigender Eingangsspannung herabgesetzt wird und umgekehrt.

3. Schaltnetzteil nach Anspruch 1 und 2, **dadurch gekennzeichnet, daß** die Ansprechschwelle über einen Komparator erzeugt wird, dessen einem Eingang eine Referenzspannung zugeführt ist und dessen anderem Eingang eine von der Eingangsspannung der Schaltungsanordnung abhängige Spannung zugeführt ist, an welchem auch die vom Stromsensor abgeleitete Spannung liegt.

4. Schaltungsanordnung nach Anspruch 1 und 2, **dadurch gekennzeichnet, daß** die Ansprechschwelle über einen Komparator erzeugt wird, dessen einem Eingang die vom Stromsensor abgeleitete Spannung zugeführt ist und an dessen anderen Eingang eine Referenzspannung angelegt ist, deren Wert in Abhängigkeit von der Eingangsspannung der Schaltungsanordnung in der Weise veränderbar ist, daß er bei zunehmender Eingangs-spannung abnimmt und umgekehrt.

$I_c max.$

$I_s$

$c$

$T$

$U_B$

$t_2$    $t_3$

$Ic max$

$\triangle Ic$

$I_s$

$Ic$

$T$

$U_B$

$t_1$    $t_3$

Fig.1

$Ic$

$Ic max$

$d$

$b$

$c$

$Ic_1$

$a$

Fig.4

$U$

$Umax.$

Fig. 2

Fig.3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-3 697 854 (BERGER) <br> * Figur 1; Spalte 1, Zeile 56 - Spalte 3, Zeile 60 * <br> --- | 1,2 | H 03 K 17/08 // <br> H 02 M 3/335 |
| Y | US-A-4 315 303 (SNYDER) <br> * Figuren; Spalte 1, Zeile 56 - Spalte 5, Zeile 50 * <br> --- | 1,2 | |
| A | GB-A-2 028 047 (BOSCH) <br> * Figuren; Seite 1, linke Spalte, Zeile 47 - rechte Spalte, Zeile 125 * <br> --- | 1-4 | |
| A | DE-A-2 415 305 (SIEMENS) <br> * Figuren 1-3; Seite 6, Zeile 9 - Seite 10, Zeile 10 * <br> --- | 1 | |
| A | GB-A-2 073 918 (STANDARD TELEPHONE & CABLES) <br> * Figuren; Seite 1, Zeile 59 - Seite 2, Zeile 9 * <br> ----- | 1-4 | |

RECHERCHIERTE SACHGEBIETE (Int. Cl.4)

H 03 K
H 02 M

Der vorliegende Recherchenbericht wurde für alle Patentansprüche erstellt

| Recherchenort | Abschlußdatum der Recherche | Prüfer |
|---|---|---|
| DEN HAAG | 18-05-1989 | CANTARELLI R.J.H. |